# EUROPÄISCHE PATENTSCHRIFT

(11) **EP 0 427 223 B1**
(45) Veröffentlichungstag und Bekanntmachung des Hinweises auf die Patenterteilung: **21.01.1998**
(21) Anmeldenummer: 90121279.5
(22) Anmeldetag: 07.11.1990
(51) Int. Cl.: G03F 7/20

(54) **Vorrichtung zur Herstellung von Druckplatten**
Apparatus for the manufacture of printing plates
Appareil pour la fabrication de plaques d'impression

(30) Priorität: 10.11.1989 DE 3937557
(43) Veröffentlichungstag der Anmeldung: 15.05.1991
(73) Patentinhaber: Krause-Biagosch GmbH, D-33649 Bielefeld (DE)
(72) Erfinder: Fischer, Hermann, W-8900 Augsburg (DE); Nemcik, Jan, W-4902 Bad Salzuflen (DE)
(74) Vertreter: Munk, Ludwig, Dipl.-Ing.

(56) Entgegenhaltungen:
- EP-A- 0 071 171
- GB-A- 2 142 442

## Beschreibung

Die Erfindung betrifft eine Vorrichtung zur Herstellung von Druckplatten gemäß Oberbegriff des Anspruchs 1.

Eine Vorrichtung dieser Art ist aus DE-U 88 13 594 bekannt. Bei dieser bekannten Anordnung ist ein den Plattentisch übergreifender, lediglich vertikal bewegbarer Saugrahmen vorgesehen, der zum Be- bzw. Entladen von einer seitlich einfahrbaren Filmkassette bzw. Leerkassette unterfahren wird. Zur Erzielung der notwendigen Registrierungen muß der Saugrahmen hier gegenüber der Filmkassette durch Registerstifte indexiert werden. Dasselbe gilt gegenüber dem Plattentisch. Dies erfordert nicht nur Zeit, was sich ungünstig auf die erzielbare Durchsatzleistung auswirkt, sondern führt zwangsläufig auch zu Verschleiß und damit zu Ungenauigkeiten. Hinzu kommt, daß bei der bekannten Anordnung vergleichsweise große Abstände zwischen den aufeinanderfolgenden Kopiervorgängen liegen, weil bei Verwendung lediglich eines Saugrahmens keine Überschneidung der einzelnen Arbeitsschritte möglich ist. Hinzu kommt, daß bei der bekannten Anordnung die Geschwindigkeit, mit welcher die seitlich einfahrbaren Kassetten bewegbar sind, aus Gründen der Lärmentwicklung sowie des Verschleißes und der Störanfälligkeit begrenzt ist.

Hiervon ausgehend ist es daher die Aufgabe der vorliegenden Erfindung, eine Vorrichtung gattungsgemäßer Art mit einfachen und kostengünstigen Mitteln so zu verbessern, daß eine hohe Durchsatzleistung erreichbar und dennoch eine schonende und störungsfreie Betriebsweise sowie eine hohe Genauigkeit gewährleistet sind.

Diese Aufgabe wird erfindungsgemäß mit den kennzeichnenden Maß-nahmen des Anspruchs 1 gelöst.

Mit den erfindungsgemäßen Maßnahmen werden die obengeschilderten Nachteile des gattungsgemäßen Standes der Technik vollständig beseitigt. Dadurch, daß die Saugrahmen am Rahmenträger befestigt sind, ist in vorteilhafter Weise nicht nur eine hohe Bewegungsgeschwindigkeit möglich, sondern entfällt auch jede Registrierung in den Endstellungen. Vielmehr können einfach Anschläge vorgesehen sein. Aus beiden Gründen resultiert eine nicht unbeträchtliche Steigerung der erzielbaren Durchsatzleistung. Eine weitere Steigerung der Durchsatzleistung resultiert in vorteilhafter Weise daraus, daß sich hier die bisher als reine Totzeiten in Erscheinung tretenden Be- und Entladezeiten und ein Kopiervorgang überschneiden können, indem der eine Saugrahmen be- bzw. entladen wird, während der auf dem anderen Saugrahmen aufgenommene Film kopiert wird und umgekehrt. Die Kopiervorgänge unter wechselweiser Verwendung des einen bzw. anderen Saugrahmens können daher sehr schnell aufeinanderfolgen. Dennoch steht für die reinen Transportvorgänge vergleichsweise viel Zeit zur Verfügung, so daß die Bewegungsabläufe mit einer Geschwindigkeit durchgeführt werden können, die eine hohe Störungssicherheit sowie einen leisen, verschleißarmen Betrieb sicherstellen. Der Wegfall der Registrierung der Saugrahmen führt ferner in vorteilhafter Weise zu einer höchst einfachen Bauweise und schonenden Betriebsweise und wirkt sich damit ebenfalls vorteilhaft auf die Erzielung eines störungsfreien Langzeitbetriebs mit gleichbleibender Genauigkeit über lange Zeiträume hinweg aus.

Vorteilhafte Ausgestaltungen und zweckmäßige Fortbildungen der übergeordneten Maßnahmen ergeben sich aus den Unteransprüchen in Verbindung mit der nachstehenden Beispielsbeschreibung anhand der Zeichnung.

In der Zeichnung zeigen:
- Figur 1: eine Ansicht eines erfindungsgemäßen Kopierautomaten mit zwei an einem schewenkbaren Rotor aufgenommen Saugrahmen,
- Figur 2: eine Draufsicht auf einen erfindungsgemäßen Kopierautomaten mit zwei Rahmensätzen mit Saugrahmen unterschiedlicher Größe,
- Figur 3: eine Draufsicht auf einen erfindungsgemäßen Kopierautomaten mit drei Saugrahmen und
- Figur 4: eine Ansicht eines erfindungsgemäßen Kopierautomaten mit auf einer liegend angeordneten Trommel aufgenommenen Saugrahmen,
- Figur 5: eine Draufsicht auf ein weiteres Beispiel.

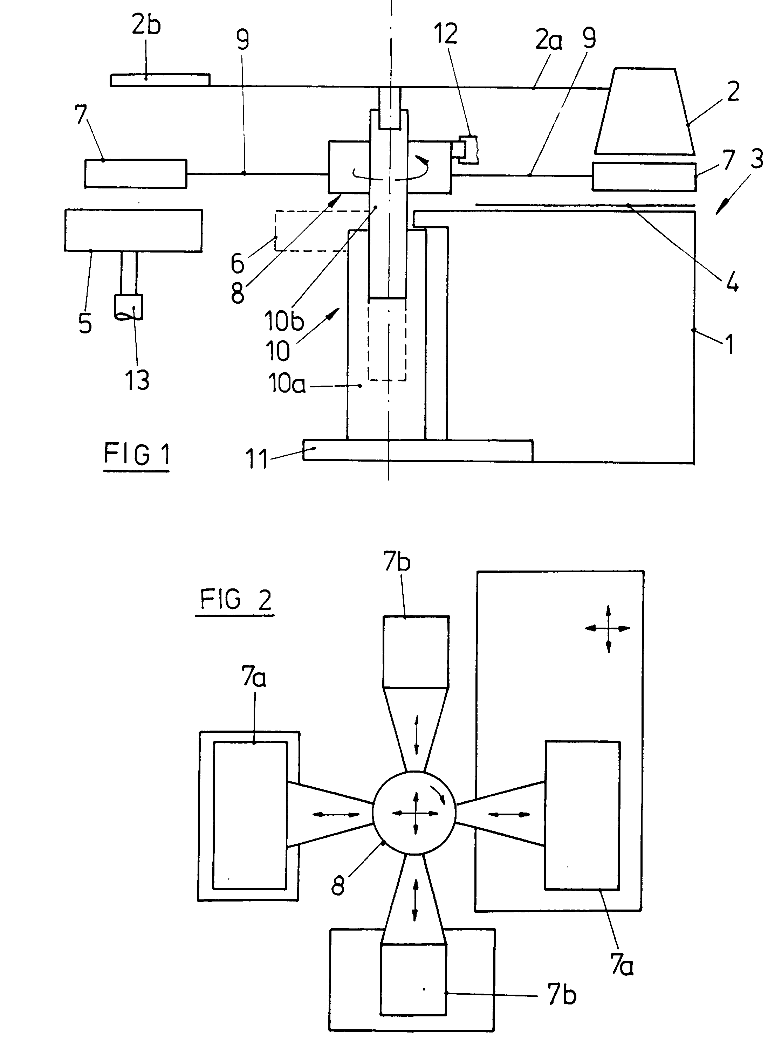

Der der Figur 1 zugrundeliegende Kopierautomat zur Herstellung von Druckplatten enthält einen Plattentisch 1, der von einer Belichtungseinrichtung 2 übergriffen ist und zusammen mit dieser eine Kopierstation 3 bildet. Der Plattentisch 1 ist mit Haltemitteln für einen auf ihm aufnehmbaren Plattenrohling 4 versehen und, wie durch Pfeile angedeutet ist, in x- und y-Richtung verschiebbar, so daß mehrere Positionen angefahren werden können, in denen jeweils ein Film auf den Plattenrohling 4 kopiert werden kann.

Dem Plattentisch 1 sind eine Filmkassette 5, in der sich die auf den Plattenrohling 4 zu kopierenden Filme befinden, und eine Leerkassette 6, in welche die kopierten Filme abgeworfen werden können, zugeordnet. Die Filmkassette 5 ist außerhalb des Plattentisches 1, hier diesem gegenüberliegend angeordnet. Die Leerkassette 6 befindet sich etwa auf halbem Wege zwischen dem Plattentisch 1 und der Filmkassette 5. Es wäre auch denkbar, die kopierten Filme auf der hergestellten Druckplatte liegenzulassen. In diesem Fall kann auf die hier vorgesehene Leerkassette 6 verzichtet werden. Dies kommt insbesondere bei der Herstellung von Zeitungsdruckplatten in Frage, bei denen pro Platte lediglich ein Film benötigt wird.

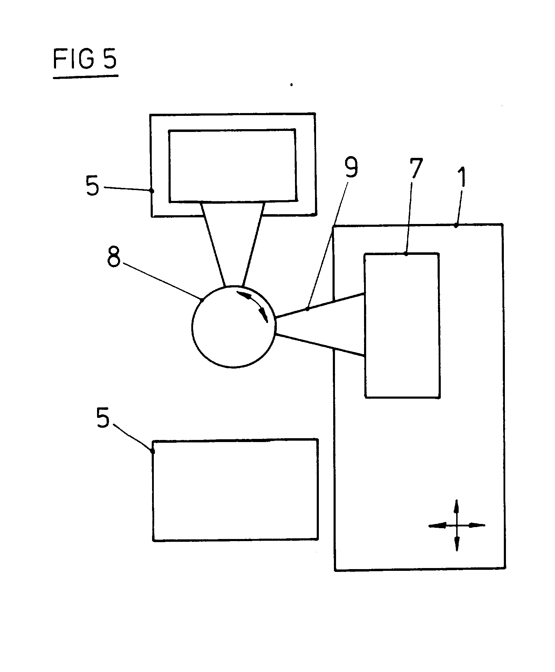

Die Filme werden jeweils mittels eines durchsichtigen Saugrahmens 7, der mit Vakuum beaufschlagbar ist, aus der Filmkassette 5, die einen Filmstapel enthält, entnommen, zum Plattentisch 1 transportiert und dort auf den Plattenrohling 4 abgesenkt und nach erfolgter Belichtung mittels der Belichtungseinrichtung in die Leerkassette 6 abgeworfen. Die dargestellte Vorrichtung enthält zwei gleiche Saugrahmen 7, die auf einer hier kreisförmigen Bahn geführt werden. Hierzu sind die Saugrahmen 7 an einem gemeinsamen, drehbar angeordneten und in Drehrichtung antreibbaren Rahmenträger 8 befestigt. Die gegenseitige Versetzung der Saugrahmen 7 am Umfang des Rahmenträgers 8 entspricht der gegenseitigen Versetzung zwischen Plattentisch 1 und Flimkassette 5 und beträgt hier dementsprechend 180°. Es wäre aber auch ohne weiteres denkbar, einen kleineren Versetzungswinkel von vorzugsweise 90° zu verwirklichen, um den Weg zwischen Filmkassette 5 und Plattentisch 1 möglichst klein zu halten. Bei einer derartigen Anordnung könnten dann auch zwei um 180° gegeneinander versetzte Filmkassetten vorgesehen sein, die im Wechsel von einem jeweils zugeordneten Saugrahmen angefahren werden, wie aus Figur 5 erkennbar ist.

In jedem Falle ist hierbei sichergestellt, daß sich jeweils ein Saugrahmen 7 im Bereich der Filmkassette 5 befindet, wenn sich der andere Saugrahmen 7 im Bereich des Plattentisches 1 befindet und umgekehrt. Der eine Saugrahmen 7 kann also bereits einen Film aus der Filmkassette 5 entnehmen, noch während der auf dem anderen Saugrahmen 7 aufgenommene Film auf den Plattenrohling 3 kopiert wird. Diese Phasenverschiebung der gegenseitigen Arbeitskreisläufe ermöglicht eine hohe Durchsatzleistung.

Der Rahmenträger 8 ist bei dem der Figur 1 zugrundeliegenden Beispiel als um eine vertikale Achse drehbarer Rotor ausgebildet, der mit radial abstehenden hier einander diametral gegenüberliegenden Armen 9 versehen ist, auf denen jeweils ein Saugrahmen 7 fixiert ist. Der die Saugrahmen 7 aufnehmende Rotor ist hier auf einem Ständer 10 drehbar aufgenommen und mit einer Drehantriebseinrichtung versehen. Anstelle eines auf dem Ständer 10 aufgenommenen Rotors für die Saugrahmen 7 könnten auch der Ständer 10 als Drehständer ausgebildet und die Saugrahmen 7 an diesem fixiert sein.

Zum gleichzeitigen Absenken der beiden Saugrahmen 7 auf die Filmkassette 5 bzw. den Plattentisch 1 ist der Rahmenträger 8 parallel zu seiner vertikalen Achse verstellbar angeordnet und/oder ausgebildet. Im dargestellten Beispiel ist hierzu der den Rahmenträger 8 aufnehmende Ständer 10 als Teleskop ausgebildet, dessen Unterteil 10a an einer Plattform 11 befestigt ist und dessen im Unterteil 10a aufgenommenes Oberteil 10b gegenüber dem stationären Unterteil 10a drehbar sowie in axialer Richtung ein- und ausfahrbar ist. Diese achsparallele Bewegbarkeit entspricht dem Abstand zwischen den Saugrahmen 7 in ihrer oberen Position und dem Plattentisch 1 bzw. dem auf diesem aufgenommenen Plattenrohling 4, so daß der tischseitige Saugrahmen 7 durch die achsparallele Bewegung des Rahmenträgers 8 ganz auf den Plattenrohling 3 absenkbar ist. Im Falle eines einteiligen Drehständers oben erwähnter Art könnten die Saugrahmen 7 gegenüber dem sie aufnehmenden Drehständer auf-und abbewegbar angeordnet sein.

Die Filmkassette 5 kann sich mit ihrer oberen Kante etwa auf dem Niveau der Tischfläche des Plattentisches 1 befinden. Da der in der Filmkassette 5 enthaltende Filmstapel jedoch abgearbeitet wird und daher in seiner Höhe abnimmt, ist eine zusätzliche Bewegung zum Ausgleich dieser Stapelhöhenabnahme erforderlich. Im dargestellten Ausführungsbeispiel soll die Filmkassette 5 hierzu entsprechend anhebbar sein, wie durch ein Hubwerk 13 angedeutet ist. Es wäre aber auch ohne weiteres denkbar, hierzu den filmkassettenseitigen Saugrahmen 7 gegenüber dem Rahmenträger 8 entsprechend abzusenken.

Der etwa als Positionsmotor ausgebildete Drehantrieb des Rahmenträgers 8 kann auf diesem angeordnet sein, was in Figur 1 kastenförmig angedeutet ist. Der Drehantrieb des Rahmenträgers 8 kann dabei so sein, daß sich eine umlaufende Drehbewegung ergibt, die selbstverständlich in dem Bogenabstand zwischen Plattentisch 1 und Filmkassette 5 entsprechenden Schritten erfolgt. Im dargestellten Ausführungsbeispiel wird der Rahmenträger 8 jeweils um den genannten Bogenwinkel vor- und zurückgeschwenkt, also reversierend angetrieben. Hierdurch ist sichergestellt, daß die zu den Saugrahmen 7 geführten, hier nicht näher dargestellten Vakuumschläuche nicht unzulässig verdreht werden und daher nicht abgekuppelt zu werden brauchen. Im Falle einer durchgehenden Drehbewegung könnte dies mittels einer Drehdurchführung erreicht werden.

Die Endstellungen der genannten Schwenkbewegung des Rahmenträgers 8 sind durch einstellbare Anschläge 12 definiert. In den Anschlagstellungen wird jeweils ein Film aus der Filmkassette 5 entnommen bzw. auf die Plattenrohling 3 abgesenkt. Auf dem Weg zwischen den Anschlagstellungen wird der jeweils vorher auf den Plattenrohling 3 kopierte Film beim Vorbeigang an der Leerkassette 6 in diese abgeworfen. Dies kann im Lauf geschehen. Es wäre aber auch denkbar, die Drehbewegung des Rahmenträgers 8 hierzu kurz zu stoppen. Die durchsichtigen Saugrahmen 7 müssen von Zeit zu Zeit gereinigt werden. Hierzu wird der Rahmenträger 8 einfach in eine Zwischenstellung zwischen seinen Anschlagstellungen gebracht, in der die Saugrahmen 7 gut zugänglich sind.

Die Belichtungseinrichtung 2 kann an der Saaldecke befestigt sein. Hier ist die Belichtungseinrichtung 2 an einem Ausleger 2a aufgenommen, der mittels eines Zapfens mit Drehfreiheitsgrad auf dem Ständer 10 bzw. hier dessen Teleskopoberteil 10b aufgenommen und lediglich gegen Verdrehen gesichert ist. Der Ausleger 2a ermöglicht eine einfache Justierung der Belichtungseinrichtung 2. Zur Vereinfachung der Lagerung kann der Ausleger 2a zweiarmig ausgebildet und auf der der Belichtungseinrichtung gegenüberliegenden Seite mit einem einstellbaren Gegengewicht 2b versehen sein.

Der in Figur 1 dargestellte Kopierautomat besteht, wie Figur 1 anschaulich erkennen läßt aus wenigen, aneinander fixier- bzw. justierbaren Baugruppen, was einen einfachen Transport sowie eine einfache Montage am Aufstellungsort ermöglicht. So ist der Plattentisch 1 an der Plattform 11 geführt. Das Teleskopoberteil 10b ist am auf der Plattform 11 aufgenommenen Teleskopunterteil 10a geführt, das hierzu als Zylinder ausgebildet ist. Auf dem als Kolben ausgebildeten Teleskopoberteil 10b sind der die Belichtungseinrichtung 2 enthaltende Ausleger 2a zentriert und der die Saugrahmen 7 enthaltende Rotor in Form des Rahmenträgers 8 samt zugeordneter Dreheinrichtung aufgenommen. Diese Baugruppen können einzeln transportiert und an Ort und Stelle schnell und zuverlässig zusammengebaut werden.

Im dargestellten Ausführungsbeispiel sollen die Saugrahmen 7 gegenüber dem Rahmenträger 8 auch unabhängig voneinander parallel zur Ständerachse verstellbar sein. Hierdurch ist es möglich, mit dem filmkassettenseitigen Saugrahmen 7 eine Schüttelbewegung zum Abschütteln eines am angesaugten Film hängengebliebenen, weiteren Films durchzuführen. Ferner ist hierdurch eine besonders exakte, satte Anlage des Films am Plattenrohling 3 erzielbar. Zur Gewährleistung einer einfachen seitlichen Justierung der Saugrahmen 7 können die Arme 9 als verlänger- bzw. verkürzbare Teleskoparme/ausgebildet sein. Auch hier können zweckmäßig einstellbare Anschläge vorgesehen sein. Eine weitere Justierungshilfe kann darin bestehen, daß der den Rahmenträger 8 bildende Drehständer auch in x- und y-Richtung verstellbar ist. Hierzu kann die Plattform 11 entsprechend verschiebbar gelagert sein.

Die Ausführung gemäß Figur 2 unterscheidet sich von der oben beschriebenen Anordnung gemäß Figur 1 im wesentlichen lediglich dadurch, daß vier Saugrahmen 7a, 7b vorgesehen sind, die paarweise eine unterschiedliche Größe aufweisen. Die paarweise zusammengehörenden Saugrahmen 7a bzw. 7b sind hier einander diametral gegenüberliegend angeordnet. Die jeweils gleich großen Saugrahmen 7a bzw. 7b bilden jeweils einen Rahmensatz. Die Saugrahmen 7a des einen Rahmensatzes können beispielsweise DIN A4-Format, die Saugrahmen 7b des anderen Rahmensatzes DIN A5-Format aufweisen. Selbstverständlich könnten auch noch mehr als zwei Rahmensätze vorgesehen sein. Jeweils ein Rahmensatz ist im Einsatz. Hierdurch ist es möglich, ohne Rahmenwechsel Filme unterschiedlichen Formats unmittelbar nacheinander zu verarbeiten. Hierzu ist lediglich der Rahmenträger 8 um die gegenseitige Versetzung der betreffenden Rahmensätze, im dargestellten Ausführungsbeispiel/um 90°, zu verstellen. Ansonsten entsprechen Aufbau und Funktionsweise der Anordnung gemäß Figur 1.

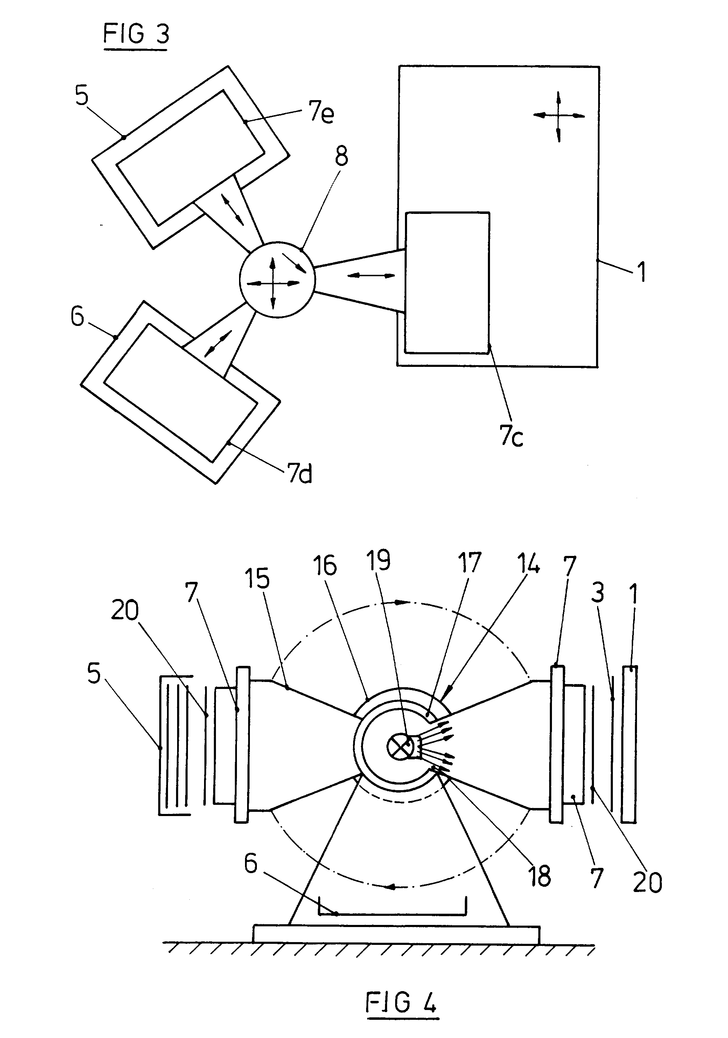

Die der Figur 3 zugrundeliegende Ausführung unterscheidet sich von der Anordnung gemäß Figur 1 im wesentlichen dadurch, daß der hier vorgesehene Rahmensatz drei Saugrahmen 7c, 7d, 7e aufweist, die um gleiche Winkel, hier um jeweils 120°, am Umfang des den Rahmenträger 8 bildenden Drehständers gegeneinander versetzt angeordnet sind. Ebenso sind der Plattentisch 1, die Filmkassette 5 und die Leerkassette 6 gegeneinander versetzt am Umfang einer bezüglich der Achse des Rahmenträgers kreisförmigen Rahmenlaufstraße gegeneinander versetzt angeordnet. Die Drehbewegung des Rahmenträgers 8 erfolgt hier in einer Richtung. Die Vakuumzuführung zu den Saugrahmen 7c, 7d, 7e erfolgt dabei zweckmäßig über eine rahmenträgerseitige Drehdurchführung und von da über rahmenträgerfest verlegte Leitungen. Die Drehbewegung erfolgt in dem Bogenabstand der Saugrahmen entsprechenden Schritten, so daß sich jeweils ein Saugrahmen, hier 7c, im Bereich des Plattentisches 1, ein weiterer Saugrahmen, hier 7d, im Bereich der Leerkassette 6 und ein weiterer Saugrahmen, hier 7e, im Bereich der Filmkassette 5 befinden. Bei dieser Anordnung ergibt sich demnach automatisch ein Abwurf des jeweils kopierten Films in die Leerkassette 6 im Stillstand.

Im übrigen können Aufbau und Funktionsweise der Anordnung gemäß Figur 1 entsprechen. Ebenso wäre es möglich, entsprechend der Ausführung gemäß Figur 2 mehr als einen Rahmensatz mit jeweils drei Saugrahmen vorzusehen, wobei jeder Rahmensatz einer unterschiedlichen Rahmengröße zugeordnet sein kann.

Bei dem der Figur 4 zugrundeliegenden Beispiel sind, wie bei der Anordnung gemäß Figur 1, zwei Saugrahmen 7 vorgesehen, die auf einer Kreisbahn geführt werden. Der Rahmenträger ist hier als um eine horizontale Achse drehbare Trommel 14 ausgebildet, die im Bereich zwischen dem hier mit vertikaler Tischebene angeordneten Plattentisch 1 und der mit vertikaler Bodenbene angeordneten Filmkassette 5 angeordnet ist und die von einer Leerkassette 6 unterfaßt ist. Der Plattentisch 1 und die Filmkassette 5 sind bezüglich der Trommelachse einander diametral gegenüberliegend angeordnet. Ebenso sind die hier vorgesehenen zwei Saugrahmen 7 einander diametral gegenüberliegend angeordnet. Die Trommel 14 besteht hier aus zwei jeweils einen Saugrahmen 7 tragenden, von radial innen nach radial außen divergierende Arme bildenden Schächten 15, die durch seitliche Ringe 16 miteinander verbunden sind, die auf einer zentralen Achse 17 gelagert sind. Die Schächte 15 gehen jeweils bis zur Achse 17 durch, die als Hohlachse ausgebildet ist und ein dem Plattentisch 1 zugewandtes Fenster 18 aufweist. Im Innenraum der als Hohlachse ausgebildeten Achse ist die Belichtungseinrichtung 19 aufgenommen. Sobald der nach innen offene Querschnitt eines Schachts 15 sich in Überdeckung mit dem Fenster 18 befindet, kann eine Belichtung des auf dem dem Plattentisch 1 zugewandten Saugrahmen 7 aufgenommenen Films 20 erfolgen, der dabei auf den auf dem Plattentisch 1 fixierten Plattenrohling 3 aufkopiert werden kann. Der Plattentisch 1 und die Filmkassette 5 sind, wie schon erwähnt, mit gleichem Winkelversatz angeordnet, wie die Saugrahmen 7, so daß auf der einen Seite ein Kopiervorgang und auf der anderen Seite die Entnahme eines neuen Films 20 aus der Filmkassette 5 erfolgen können. Durch Drehung der Trommel um den Winkelversatz, hier um 180°, erfolgt ein Stellungswechsel der Saugrahmen 7, wobei der den kopierten Film enthaltende Saugrahmen 7 beim Vorbeigang an der Leerkassette 6 vom Vakuum getrennt wird, wobei der Film in die Leerkassette 6 abgeworfen wird.

Die Saugrahmen 7 sind hier ebenfalls trommelfest angeordnet. Der Plattentisch 1 und die Filmkassette 5 können dabei lotrecht zur Tischebene bzw. Kassettenbodenebene an die Trommel anstellbar sein. Es wäre aber auch denkbar, die Schächte 15 teleskopartig auszubilden, um die Saugrahmen 7 in Wirkverbindung mit dem Plattentisch 1 bzw. der Filmkassette 5 bringen zu können, die dabei keine Stellbewegung machen müßten.

Der grundsätzlich Aufbau der Anordnung gemäß Fig. 5 entspricht der Anordnung gemäß Fig. 1 mit dem Unterschied, daß, wie schon erwähnt, die Saugrahmen 7 und die diese aufnehmenden Arme 9 um 90° am Umfang des zugeordneten, hier um eine vertikale Achse schwenkbaren Rahmenträgers 8 gegeneinander besetzt angeordnet sind. Dieselbe Anordnung wäre auch bei horizontaler Rahmenträgerschwenkachse möglich. Neben dem Plattentisch 1 sind hier zwei bezüglich des Rahmenträgers 8 einander gegenüberliegende, also um 180° gegeneinander versetzte Filmkassetten 5 vorgesehen, die im Wechsel von jeweils einem Saugrahmen 7 angefahren werden. Der Rahmenträger 8 brauch hierzu lediglich um jeweils 90° hin - und herschwenken. Hierbei ergeben sich besonders kurze Wege und Taktzeiten.

Anstelle der Filmkassetten 5 könnten auch Filmablageplattformen mit kassettenähnlichen Registrierorganen vorgesehen sein, die ihrerseits mittels eines Zubringers aus einer gemeinsamen Kassette beschickbar sind. Ebenso wäre es möglich, anstelle von zwei Filmkassetten eine zwischen den zwei Entnahmepositionen hin- und herbewegbare Filmkassetten vorzusehen.

## Patentansprüche

1. Vorrichtung zur Herstellung von Druckplatten mit einer einen Plattentisch (1) und eine diesem zugeordnete Belichtungseinrichtung aufweisenden Kopierstation (2), der mindestens eine vorzugsweise durch eine Filmkassette (5) gebildete Filmaufnahmeeinrichtung für unkopierte Filme zugeordnet ist, wobei jeweils der auf einen Plattenrohling (3) zu kopierende Film mittels eines bewegbaren Saugrahmens (7) von einer zugeordneten Filmaufnahmeeinrichtung entnehmbar, an dem auf dem Plattentisch (1) aufnehmbaren Plattenrohling (3) in Anlage bringbar und nach erfolgter Belichtung abgebbar ist, **dadurch gekennzeichnet, daß** mehrere Saugrahmen (7) vorgesehen sind, von denen jeweils wenigstens zwei mit der dem Weg zwischen der zumindest vorgesehenen einen Filmaufnahmeeinrichtung und dem Plattentisch (1) entsprechenden Versetzung am Umfang eines zumindest um den Abstandswinkel der Saugrahmen (7) drehbeweglichen Rahmenträger (8,14) befestigt sind.

2. Vorrichtung nach Anspruch 1, **dadurch gekennzeichnet, daß** der Rahmenträger (8,14) als um seine Achse dreh- bzw. schwenkbarer Körper ausgebildet ist, der mit radial abstehenden, jeweils einen Saugrahmen (7) aufnehmenden Armen (9,15) versehen ist.

3. Vorrichtung nach Anspruch 2, **dadurch gekennzeichnet, daß** der Rahmenträger (8) als um eine vertikale Achse dreh- bzw. schwenkbarer Rotor ausgebildet ist.

4. Vorrichtung nach Anspruch 3, **dadurch gekennzeichnet, daß** der Rahmenträger (8) parallel zu seiner Achse zumindest um den bei der Durchführung der Dreh- bzw. Schwenkbewegung vorhandenen Abstand zwischen Saugrahmen (7) und Plattentisch (1) verstellbar ist.

5. Vorrichtung nach Anspruch 4, **dadurch gekennzeichnet, daß** der Rotor (8) auf einem teleskopartig ausgebildeten Ständer (10) aufgenommen ist.

6. Vorrichtung nach einem der vorhergehenden Ansprüche, **dadurch gekennzeichnet, daß** die Belichtungseinrichtung (2) mittels eines ein Gegengewicht (2b) tragenden Auslegers (2a) auf dem dem Saugrahmen (7) zugeordneten Ständer (10) zentriert ist.

7. Vorrichtung nach einem der vorhergehenden Ansprüche, **dadurch gekennzeichnet, daß** die Filmkassette (5) zumindest um die Höhe des in ihr aufnehmbaren Filmstapels parallel zu ihrem Boden verstellbar ist.

8. Vorrichtung nach einem der vorhergehenden Ansprüche, **dadurch gekennzeichnet, daß** die Saugrahmen (7) gegenüber dem Rahmenträger (8,14) unabhängig voneinander parallel zur Rahmenfläche verstellbar sind.

9. Vorrichtung nach einem der vorhergehenden Ansprüche 2 bis 8, **dadurch gekennzeichnet, daß** die Saugrahmen (7) aufnehmenden Arme (9,15) teleskopartig ein- bzw. ausfahrbar sind.

10. Vorrichtung nach einem der vorhergehenden Ansprüche, **dadurch gekennzeichnet, daß** der Rahmenträger (8,14) parallel zur Fläche des Plattentisches (1) verstellbar ist.

11. Vorrichtung nach einem der vorhergehenden Ansprüche, **dadurch gekennzeichnet, daß** der Plattentisch (1) parallel zu seiner Tischfläche verstellbar ist.

12. Vorrichtung nach einem der vorhergehenden Ansprüche, **dadurch gekennzeichnet, daß** der Rahmenträger (8,14) reversierend zwischen zwei Anschlagstellungen hinund herschwenkbar ist.

13. Vorrichtung nach einem der vorhergehenden Ansprüche, **dadurch gekennzeichnet, daß** die Leerkassette (6) im Schwenkbereich des Rahmenträgers (8,14) zwischen Plattentisch (1) und Filmkassette (5) angeordnet ist.

14. Vorrichtung nach Anspruch 1, **dadurch gekennzeichnet, daß** der Rahmenträger als um eine horizontale Achse drehbare Trommel (14) ausgebildet ist, unterhalb der die Leerkassette (6) angeordnet ist und die von der Filmkassette (5) und dem Plattentisch (1) flankiert ist, die mit vertikaler Boden- bzw. Tischebene angeordnet sind.

15. Vorrichtung nach Anspruch 13, **dadurch gekennzeichnet, daß** der Plattentisch (1) und die Filmkassette (5) senkrecht zur Tisch- bzw. Bodenebene an den jeweils gegenüberliegenden Saugrahmen (7) anstellbar sind.

16. Vorrichtung nach Anspruch 13, **dadurch gekennzeichnet, daß** die Trommel (14) auf einer stationären Hohlachse (17) aufgenommen ist, die ein dem Plattentisch (1) zugewandtes Belichtungsfenster (18) aufweist und eine Belichtungseinrichtung (19) enthält.

17. Vorrichtung nach einem der vorhergehenden Ansprüche 13 bis 15, **dadurch gekennzeichnet, daß** die radial abstehenden, die Saugrahmen (7) aufnehmenden Arme der Trommel (14) als nach außen sich erweiternde, bis zur Hohlachse (17) reichende Belichtungsschächte (15) ausgebildet sind.

18. Vorrichtung nach einem der vorhergehenden Ansprüche, **dadurch gekennzeichnet, daß** auf dem Rahmenträger (8,14) mehrere, alternativ zum Einsatz kommende Rahmensätze mit jeweils mehreren Saugrahmen (7a,7b) aufgenommen sind, wobei jedem Rahmensatz eine spezielle Rahmengröße zugeordnet ist.

19. Vorrichtung nach Anspruch 17, **dadurch gekennzeichnet, daß** zwei Rahmensätze vorgesehen sind, von denen einer Saugrahmen (7a) für DIN A4-Format und einer Saugrahmen (7b) für DIN A5-Format aufweist.

20. Vorrichtung nach einem der vorhergehenden Ansprüche, **dadurch gekennzeichnet, daß** pro Rahmensatz zwei Saugrahmen (7) vorgesehen sind, die einander diametral gegenüberliegend angeordnet sind.

21. Vorrichtung nach Anspruch 1, **dadurch gekennzeichnet, daß** pro Rahmensatz mehr als zwei Saugrahmen (7c,7d,7e) vorgesehen sind, die gleichmäßig voneinander beabstandet sind.

22. Vorrichtung nach Anspruch 20 oder 21, **dadurch gekennzeichnet, daß** der Rahmenträger (8) in Drehrichtung einsinnig antreibbar ist.

23. Vorrichtung nach einem der vorhergehenden Ansprüche, **dadurch gekennzeichnet, daß** der Rahmenträger (8) mindestens zwei um 90° gegeneinander versetzte Saugrahmen (7) trägt, wobei zwei bezüglich des Rahmenträgers (8) einander gegenüberliegende Filmaufnahmeeinrichtungen bzw. Filmkassetten vorgesehen sind, die im Wechsel von jeweils einem Saugrahmen (7) anfahrbar sind.

24. Vorrichtung nach einem der vorhergehenden Ansprüche, **dadurch gekennzeichnet, daß** mindestens eine Leerkassette (6) für kopierte Filme vorgesehen ist.

## Claims

1. Apparatus for the production of printing plates with a copying station (2) comprising a plate table (1) and an exposure device cooperating therewith, said copying station operating in conjunction with at least one film holder device for uncopied films, formed preferably by a film cassette (5), and with a movable suction frame (7) for removing each film to be copied onto a blank plate (3) from an associated film holder device, laying said film on the blank plate (3) held on the plate table (1), and discharging said film after exposure, characterized in that a plurality of suction frames (7) are provided, at least two of which are mounted, with an offset corresponding to the distance between the at least one film holder device provided and the plate table (1), on the circumference of a frame carrier (8, 14) rotatable at least through the offset angle of the suction frames (7).

2. Apparatus according to Claim 1, characterized in that the frame carrier (8, 14) is constructed in the form of a body rotatable or as the case may be pivotable about its axis, and provided with radially projecting arms (9, 15) each carrying a suction frame (7).

3. Apparatus according to Claim 2, characterized in that the frame carrier (8) is constructed in the form of a rotor rotatable or pivotable about a vertical axis.

4. Apparatus according to Claim 3, characterized in that the frame carrier (8) is shiftable parallel with its axis at least by a distance equal to the clearance between suction frame (7) and plate table (1) during the execution of the rotary or pivoting motion.

5. Apparatus according to Claim 4, characterized in that the rotor (8) is mounted on a telescopic stand (10).

6. Apparatus according to any one of the preceding claims, characterized in that the exposure device (2) is centrally supported on the stand (10) for the suction frame (7) by means of a boom (2a) which carries a counterweight (2b).

7. Apparatus according to any one of the preceding claims, characterized in that the film cassette (5) is shiftable parallel with its bottom [sic] at least by an amount equal to the height of the stack of film which can be contained in the said cassette.

8. Apparatus according to any one of the preceding claims, characterized in that the suction frames (7) are, independently of one another, shiftable in relation to the frame carrier (8, 14) in a direction parallel with the frame plane.

9. Apparatus according to any one of the preceding Claims 2 to 8, characterized in that the arms (9, 15) carrying the suction frames (7) are telescopically retractable and extensible.

10. Apparatus according to any one of the preceding claims, characterized in that the frame carrier (8, 14) is shiftable parallel with the plane of the plate table (1).

11. Apparatus according to any one of the preceding claims, characterized in that the plate table (1) is shiftable parallel with its table plane.

12. Apparatus according to any one of the preceding claims, characterized in that the frame carrier (8, 14) can be made to execute a back and forward motion between two stop positions.

13. Apparatus according to any one of the preceding claims, characterized in that the empty cassette (6) is arranged in the area swept by the frame carrier (8, 14) between plate table (1) and film cassette (5).

14. Apparatus according to Claim 1, characterized in that the frame carrier is constructed in the form of a drum (14) rotatable about a horizontal axis, with the empty cassette (6) arranged underneath the said drum, which is flanked by the film cassette (5) and the plate table (1) which are arranged with, respectively, their bottom plane and table plane vertical.

15. Apparatus according to Claim 13 [sic], characterized in that the plate table (1) and the film cassette (5) are adjustable, perpendicularly to, respectively, the table plane and the bottom plane, with respect to the individual suction frame (7) with which they are in register.

16. Apparatus according to Claim 13 [sic], characterized in that the drum (14) is mounted on a fixed hollow axle (17) which has an exposure window (18) facing the plate table (1) and contains an exposure device (19).

17. Apparatus according to any one of the preceding Claims 13 [sic] to 15 [sic], characterized in that the radially projecting arms of the drum (14) which carry the suction frames (7) are constructed in the form of exposure tunnels (15) which widen in the [radially] outward direction and extend to the hollow axle (17).

18. Apparatus according to any one of the preceding claims, characterized in that a plurality of alternatively usable frame sets, each with a plurality of suction frames (7a, 7b), are mounted on the frame carrier (8, 14), each frame set being assigned to a particular frame size.

19. Apparatus according to Claim 17 [sic], characterized in that two frame sets are provided, one with suction frames (7a) for DIN A4 format and one with suction frames (7b) for DIN A5 format.

20. Apparatus according to any one of the preceding claims, characterized in that two suction frames (7), arranged diametrically opposite each other, are provided for each frame set.

21. Apparatus according to Claim 1, characterized in that more than two suction frames (7c, 7d, 7e), spaced at equal intervals from one another, are provided for each frame set.

22. Apparatus according to Claim 20 or Claim 21, characterized in that the frame carrier (8) can be driven in rotation in one direction.

23. Apparatus according to any one of the preceding claims, characterized in that the frame carrier (8) carries at least two suction frames (7) set at 90° to one another, two film holder devices or film cassettes being provided, opposite one another with respect to the frame carrier (8), and approachable alternately by one or other of the suction frames (7).

24. Apparatus according to any one of the preceding claims, characterized in that at least one empty cassette (6) is provided for copied films.

## Revendications

1. Dispositif de fabrication de plaques d'impression, avec un poste de copiage (3) présentant un plateau porte-plaque (1) et un appareil d'exposition associé à ce plateau, poste auquel est associé au moins un dispositif récepteur de films non copiés, formé de préférence par une cassette de film (5), le film respectif à copier sur une plaque brute (4) pouvant être prélevé d'un dispositif associé récepteur de films au moyen d'un cadre aspirant mobile (7), amené en application contre la plaque brute (4) pouvant être reçue sur le plateau porte-plaque (1), et délivré une fois l'exposition effectuée, **caractérisé** en ce que plusieurs cadres aspirants (7) sont prévus, dont au moins deux sont respectivement fixés, avec le décalage correspondant à la distance entre le plateau porte-plaque (1) et le dispositif récepteur de films prévu au moins au nombre de un, sur la périphérie d'un support de cadres (8, 14) mobile en rotation au moins sur la distance angulaire entre les cadres aspirants (7).

2. Dispositif selon la revendication 1, **caractérisé** en ce que le support de cadres (8, 14) est réalisé sous la forme d'un corps rotatif ou encore pivotant autour de son axe, corps qui est pourvu de bras radialement saillants (9, 15), recevant chacun un cadre aspirant (7).

3. Dispositif selon la revendication 2, **caractérisé** en ce que le support de cadres (8) est réalisé sous la forme d'un rotor rotatif ou encore pivotant autour d'un axe vertical.

4. Dispositif selon la revendication 3, **caractérisé** en ce que le support de cadres (8) peut être déplacé parallèlement à son axe au moins de la distance présente entre le cadre aspirant (7) et le plateau porte-plaque (1) lors de l'exécution du mouvement de rotation ou encore de pivotement.

5. Dispositif selon la revendication 4, **caractérisé** en ce que le rotor (8) est reçu sur une colonne (10) réalisée télescopique.

6. Dispositif selon une des revendications précédentes, **caractérisé** en ce que l'appareil d'exposition (2) est, au moyen d'un avant-bras (2a) portant un contrepoids (2b), centré sur la colonne (10) associée au cadre aspirant (7).

7. Dispositif selon une des revendications précédentes, **caractérisé** en ce que la cassette de film (5) peut être déplacée parallèlement à son fond au moins de la hauteur de la pile de films qui peut être reçue dans cette cassette.

8. Dispositif selon une des revendications précédentes, **caractérisé** en ce que les cadres aspirants (7) peuvent être déplacés par rapport au support de cadres (8, 14) indépendamment entre eux, parallèlement à la surface du cadre.

9. Dispositif selon une des revendications précédentes, **caractérisé** en ce que les bras (9, 15) recevant des cadres aspirants (7) peuvent être télescopiquement rentrés ou sortis.

10. Dispositif selon une des revendications précédentes, **caractérisé** en ce que le support de cadres (8, 14) peut être déplacé parallèlement à la surface du plateau porte-plaque (1).

11. Dispositif selon une des revendications précédentes, **caractérisé** en ce que le plateau porte-plaque (1) peut être déplacé parallèlement à sa surface de plateau.

12. Dispositif selon une des revendications précédentes, **caractérisé** en ce que le support de cadres (8, 14) peut être pivoté en va-et-vient, en navette, entre deux positions de butée.

13. Dispositif selon une des revendications précédentes, **caractérisé** en ce que la cassette vide (6) est disposée dans la région de pivotement du support de cadres (8, 14) entre le plateau porte-plaque (1) et la cassette de film (5).

14. Dispositif selon la revendication 1, **caractérisé** en ce que le support de cadres est réalisé sous forme de tambour (14) rotatif autour d'un axe horizontal, tambour en dessous duquel est disposée la cassette vide (6) et qui est flanqué de la cassette de film (5) et du plateau porte-plaque (1), qui sont disposés avec des plans, respectivement de fond ou de plateau, verticaux.

15. Dispositif selon la revendication 13, **caractérisé** en ce que le plateau porte-plaque (1) et la cassette de film (5) peuvent être appliqués, perpendiculairement à leur plan de plateau ou, respectivement, de fond, contre les cadres aspirants (7) respectivement opposés.

16. Dispositif selon la revendication 13, **caractérisé** en ce que le tambour (14) est reçu sur un arbre creux stationnaire (17), qui présente une fenêtre d'exposition (18) tournée vers le plateau porte-plaque (1) et qui contient un appareil d'exposition (19).

17. Dispositif selon une des revendications précédentes 13 à 15, **caractérisé** en ce que les bras radialement saillants du tambour (14) qui reçoivent les cadres aspirants (7) sont réalisés sous forme de puits d'exposition (15) s'élargissant vers l'extérieur et s'étendant jusqu'à l'arbre creux (17).

18. Dispositif selon une des revendications précédentes, **caractérisé** en ce que plusieurs jeux de cadres, à utiliser alternativement et comprenant chacun plusieurs cadres aspirants (7a, 7b), sont reçus sur le support de cadres (8, 14), une taille particulière de cadre étant affectée à chaque jeu de cadres.

19. Dispositif selon la revendication 17, **caractérisé** en ce que deux jeux de cadres sont prévus, dont l'un présente des cadres aspirants (7a) pour le format DIN A4 et l'autre des cadres aspirants (7b) pour le format DIN A5.

20. Dispositif selon une des revendications précédentes, **caractérisé** en ce que deux cadres aspirants (7), qui sont disposés diamétralement opposés, sont prévus par jeu de cadres.

21. Dispositif selon la revendication 1, **caractérisé** en ce que plus de deux cadres aspirants (7c, 7d, 7e), qui sont régulièrement espacés les uns des autres, sont prévus par jeu de cadres.

22. Dispositif selon la revendication 20 ou 21, **caractérisé** en ce que le support de cadres (8) peut être entraîné dans un seul sens dans la direction de rotation.

23. Dispositif selon une des revendications précédentes, **caractérisé** en ce que le support de cadres (8) porte aux moins deux cadres aspirants (7) mutuellement décalés de 90°, deux dispositifs récepteurs de films ou encore cassettes de films mutuellement opposé(e)s par rapport au support de cadres (8) étant prévu(e)s, qui peuvent être alternativement approchés par un cadre aspirant (7) respectif.

24. Dispositif selon une des revendications précédentes, **caractérisé** en ce qu'il est prévu au moins une cassette vide (6) pour des films copiés.
